Europäisches Patentamt

European Patent Office

Office européen des brevets

(11) Veröffentlichungsnummer: **0 158 127**
**A2**

# EUROPÄISCHE PATENTANMELDUNG

(21) Anmeldenummer: 85102666.6

(22) Anmeldetag: 08.03.85

(51) Int. Cl.⁴: **H 05 K 13/00**

(30) Priorität: 26.03.84 DE 3411125

(43) Veröffentlichungstag der Anmeldung:
16.10.85 Patentblatt 85/42

(84) Benannte Vertragsstaaten:
AT BE CH DE FR GB IT LI LU NL SE

(71) Anmelder: Lemmer, Alfred
Machtlfingerstrasse 24
D-8000 München 70(DE)

(72) Erfinder: Lemmer, Alfred
Machtlfingerstrasse 24
D-8000 München 70(DE)

(74) Vertreter: Schmidt-Evers, Jürgen, Dipl.-Ing. et al,
Patentanwälte Dipl.-Ing. H. Mitscherlich Dipl.-Ing. K.
Gunschmann Dipl.-Ing. Dr.rer.nat. W. Körber Dipl.-Ing. J.
Schmidt-Evers Dipl.-Ing. W. Melzer Steinsdorfstrasse 10
D-8000 München 22(DE)

(54) Vorrichtung zum Greifen von elektronischen Bauelementen, insbesondere IC's.

(57) Die Erfindung bezieht sich auf eine Vorrichtung zum Greifen von elektronischen Bauelementen, insbesondere IC's, mit einer Greifzange, deren Spannbacken aufeinanderzu und voneinanderweg beweglich sind, und bezweckt, die Vorrichtung so auszugestalten, daß die Abmessung der Greifzange ohne einen Austausch derselben wahlweise an die Abmessung des zu ergreifenden Bauelements anpaßbar ist. Dies wird dadurch erreicht, daß die Greifzange (3) in mehrere in einer Reihe (15, 16) angeordnete Zangenabschnitte (4, 5) unterteilt ist, von denen wenigstens ein Zangenabschnitt (5) in einer ersten Führung(14) zwischen einer zurückgezogenen Bereitschaftsstellung (mit durchgezogenen Linien gezeichnet) und einer vorgeschobenen Gebrauchsstellung (strich-punktiert gezeichnet) verschiebbar sind.

FIG.1

Croydon Printing Company Ltd.

EP 0 158 127 A2

Ø158127

Vorrichtung zum Greifen von elektronischen Bauelementen, insbesondere IC's

Die Erfindung bezieht sich auf eine Vorrichtung nach dem Oberbegriff des Anspruchs 1.

Vorrichtungen dieser Bauart sind in der Praxis eingesetzt und deshalb bekannt. Sie dienen dazu, elektronische Bauteile, insbesondere Leiterplatten mit elektronischen Bauelementen, insbesondere IC's, zu bestücken. Das Bestücken erfolgt dadurch, daß die elektronischen Bauelemente mittels der Greifzange der Vorrichtung an einem Entnahmeort ergriffen und zu einem Einsatzort getragen und diesem übergeben werden.

Insbesondere dann, wenn das elektronische Bauelement nicht nur übergeben, sondern mittels der Vorrichtung am Einsatzort auch montiert werden soll, ist ein verhältnismäßig fester Griff des Bauelementes erforderlich, um zu verhindern, daß es innerhalb der Greifzange verkantet, sich verschiebt oder dergleichen. Eine solche Gefahr besteht insbesondere dann, wenn Bauelemente größerer Länge von den Spannflächen der Greifzange nur im Bereich ihrer Mitte erfaßt werden, so daß sich beim Auf- bzw. Einsetzen der Bauelemente ungünstige Hebelarme ergeben, die zu einer Verkantung bzw. Verschiebung des Bauelementes in der Greifzange führen können.

Es ist deshalb ein großflächiges Ergreifen des Bauelementes anzustreben, d.h., die Greifzange soll das Bauelement möglichst etwa auf seiner ganzen Länge ergreifen.

In der Praxis trägt man dieser Forderung dadurch Rechnung, daß für Bauelemente unterschiedlicher Länge Greifzangen unterschiedlicher Breite eingesetzt werden, wobei

0158127

bei der Auswahl der Breite der Greifzange die Länge des betreffenden Bauelements berücksichtigt wird, um es möglichst auf seiner gesamten Länge zu übergreifen.

So zu verfahren ist zwar möglich, jedoch umständlich und auch zeitraubend, weil nicht nur die Längenabmessungen der Bauelemente, sondern auch deren Dicke sehr unterschiedlich sind. Deshalb ist bei der bekannten Arbeitsweise ein häufiger Wechsel der Greifzange erforderlich, wodurch nicht nur deshalb hohe Kosten vorgegeben sind, weil eine Vielzahl von Greifzangen bereitzuhalten sind, sondern durch den Austausch erforderlicher Greifzangengrößen die Leistung der Vorrichtung erheblich beschränkt ist.

Der Erfindung liegt die Aufgabe zugrunde, eine Vorrichtung der eingangs bezeichneten Bauart so auszugestalten, daß die Abmessung der Greifzange ohne einen Austausch derselben nach herkömmlicher Art wahlweise an die Abmessung des zu ergreifenden Bauelements anpaßbar ist.

Diese Aufgabe wird durch die Merkmale des Anspruchs 1 gelöst.

Bei der erfindungsgemäßen Ausgestaltung ist die Greifzange in mehrere, in einer Reihe angeordnete Zangenabschnitte unterteilt, die zwischen einer zurückgezogenen Bereitschaftsstellung und einer vorgeschobenen Gebrauchsstellung verschiebbar sind. Die erfindungsgemäße Ausgestaltung ermöglicht es, die Breite der Greifzange dadurch an die Länge des zu ergreifenden Bauelements anzupassen, daß eine solche Anzahl Zangenabschnitte aus ihrer zurückgezogenen Bereitschaftsstellung in die vorgeschobene Gebrauchsstellung vorgeschoben werden, daß die so geschaffene Breite der Greifzange etwa der Länge des Bauelements entspricht. Das Bauelement kann somit nicht nur sicher

0158127

ergriffen, sondern auch sicher montiert werden, d.h.,
zum Beispiel in eine Leiterplatte eingesetzt werden,
wobei bedenkliche Kippmomente nicht auf das Bauelement
wirken können, weil es auf etwa seiner gesamten Länge
ergriffen wird.

Die Anpaßbarkeit der Greifzange ist abhängig von der
Breite der Zangenabschnitte.

Es empfiehlt sich, die Zangenabschnitte etwa 5 mm breit
zu bemessen. Mit einer solchen Stufung läßt sich eine
befriedigende Anpaßbarkeit an alle möglichen Zwischenlängen der Bauelemente ermöglichen.

Die erfindungsgemäße Ausgestaltung führt zu einem weiteren Vorteil, der beim Einsatz für IC's zum Tragen
kommt. IC's weisen bekanntlich U-förmige Anschlußfahnen
auf, die beim Einsetzen eines IC's in eine Leiterplatte
oder dergleichen geringfügig aufeinanderzu zusammenzudrücken sind, um die Spitzen der Anschlußfahnen in Übereinstimmung mit dem Lochraster der Leiterplatte zu bringen. Dieses Zusammendrücken der Anschlußfahnen wird durch
die Greifzange bewerkstelligt. Beim Greifen von IC's
ist es somit nicht nur aus Gründen eines sicheren Griffs
erforderlich, daß IC auf seiner möglichst ganzen Länge
zu übergreifen, sondern der Übergriff ist auch deshalb
erforderlich, um alle Anschlußfahnen in die gewünschte
Position zusammendrücken zu können. Die erfindungsgemäße
Ausgestaltung eignet sich deshalb besonders gut zur Handhabung von IC's. Es hat sich gezeigt, daß mit einem
Stufensprung von etwa 5 mm für die Zangenabschnitte die
Anschlußfahnen unterschiedlich lang bemessener IC's
sicher beaufschlagt werden können.

Die Ausgestaltung nach Anspruch 2 führt zu einer Vereinfachung des Antriebs für die Zangenabschnitte, um sie
zwischen der Bereitschaftsstellung und der Gebrauchsstellung zu verschieben. Aufgrund der auf die Zangenabschnitte wirkenden Federkraft bedarf es lediglich eines
einfach wirkenden Stößels.

Die Ausbildungen nach den Ansprüchen 3 und 5 sind deshalb
vorteilhaft, weil sich die translatorische Bewegung zueinandergehöriger Spannbacken aus konstruktiven Gründen
erheblich einfacher verwirklichen läßt, als eine kreisbogenförmige Bewegung, wie sie durch den Stand der Technik
bekannt ist. Bei einer kreisbogenförmigen Bewegung der
Spannbacken nehmen deren Längskanten unterschiedliche
Winkelstellungen ein, so daß eine für das Verschieben
zwischen der Bereitschaftsstellung und der Gebrauchsstellung notwendige erste Führung nur sehr erschwert verwirklicht werden könnte. Dagegen läßt sich bei der erfindungsgemäßen Ausgestaltung nicht nur eine einfache
Führung verwirklichen, sondern die Spannflächen der
Spannbacken verlaufen unabhängig vom jeweiligen Abstand
zueinandergehöriger Spannbacken immer parallel, so daß
die Bauelemente sicher ergriffen werden können. Dieser
Vorteil ist insbesondere dann wirksam, wenn Bauelemente
mit etwa rechteckigem Querschnitt gehandhabt werden sollen.wie es bei IC's der Fall ist.

Durch eine Ausgestaltung gemäß Anspruch 4 ist gewährleistet, daß bei allen Spannpositionen die Mitte der
Bauelemente immer gleich ist. Dies ist insbesondere
dann von Vorteil, wenn eine erfindungsgemäße Vorrichtung
zum programmgesteuerten automatischen Einsetzen von Bauelementen eingesetzt wird.

Der Anspruch 6 führt deshalb zu einer Vereinfachung, weil
die Führungen aller in der jeweiligen Reihe liegenden Spannbacken
zu einem Führungsblock zusammengefaßt sind und deshalb
nicht nur die zweite Führung deshalb erheblich vereinfacht
ist, weil nicht alle Zangenabschnitte sondern nur zwei

D158127

Blöcke zu führen sind und          nicht alle Zangenabschnitte mit Antrieben versehen werden müssen, sondern
lediglich die beiden Führungsblöcke.

Die Ansprüche 7 bis 9 beziehen sich auf einfache und
vorteilhafte Ausbildungen der ersten Führung, wobei
nicht nur die Führungsmerkmale selbst, sondern auch
die Ausgestaltungsmerkmale zur Beaufschlagung der Spannbacken mittels Druckfeder zu einer platzsparenden Bauweise führen.

In den Ansprüchen 1o bis 12 ist ein einfacher und ebenfalls platzsparender Antrieb für die Spann- bzw. Lösebewegung der Spannbacken enthalten, wobei auf das bewährte Mittel eines Zahnstangentriebs zurückgegriffen
wird, um die Führungsblöcke der ersten Führung gleichzeitig und mit gleicher Geschwindigkeit aufeinanderzu
und voneinanderweg zu bewegen.

Die Ansprüche 13 und 14 beziehen sich auf das Vorschieben
der Zangenabschnitte aus ihrer Bereitschaftsstellung
in ihre Gebrauchsstellung mittels mehrerer oder bevorzugt nur eines Stößels. Angesichts einer denkbaren
Vielzahl von Zangenabschnitten bzw. Spannbacken führen
die Ausgestaltungen insbesondere dann zu einer ganz erheblichen Vereinfachung, wenn nur ein Stößel vorgesehen
ist, der alle Zangenabschnitte zu beaufschlagen vermag.
Bei einer solchen Ausführungsform bedarf es einer Bewegung des Stößels sowohl in Richtung auf die Spannbacken
als auch längs der Spannbackenreihen, um wahlweise die
Anzahl Spannbacken in die Gebrauchsstellung vorschieben
zu können, die erforderlich ist.

Dabei wird gemäß Anspruch 15 ermöglicht, den Stößel so
breit auszugestalten, daß er in jeder Abstandsposition
der zueinandergehörigen Spannbacken die Spannbacken zu
beaufschlagen vermag.

Die Ausbildung nach Anspruch 16 ermöglicht eine Aufnahme des Stößels in der Vorrichtung dann, wenn nur eine schmale Greifzange benötigt wird. In diesem Fall befindet sich der Stößel im freien Raum vor dem ersten Spannbackenabschnitt.

Die Ansprüche 17 bis 24 beziehen sich auf Ausgestaltungsformen für das wahlweise Ausstoßen des ergriffenen Bauelements aus der Greifzange bzw. aus den Spannbacken. Ein Ausstoßer ist insbesondere dann vorteilhaft, wenn die Vorrichtung nicht nur zum Übertragen von Bauelementen von einem Ort zum anderen, sondern zum Montieren benutzt wird, beispielsweise zum Einsetzen von IC's in Leiterplatten. Erfindungsgemäße Ausstoßer verhindern zum einen, daß das abgesetzte Bauelement durch beispielsweise Kleboder Klemmwirkung an der Greifzange haftet und beim Zurückholen der Vorrichtung aus seinem Bestimmungsort zurückgezogen wird. Zum anderen lassen sich die Ausstoßer auch vorteilhaft dazu benutzen, ein Bauelement mit seinen Anschlußfahnen in die Montagestellung hinein auszustoßen.

Soweit die Ansprüche 21 und 22 betroffen sind, wird auf die schon angeführten Vorteile der Ausgestaltungen nach den Ansprüchen 13 und 14 verwiesen. Im weiteren sind in den Ansprüchen 18 bis 24 Ausgestaltungsmerkmale enthalten, die sich durch einfache und platzsparende Bauweise auszeichnen.

Die Anordnung der Ausstoßer an den Spannbacken hat den Vorteil, daß die Ausstoßer an einer Veränderung des Abstands zwischen zueinandergehörigen Spannbacken teilnehmen und deshalb die Bauelemente durch die Ausstoßer immer in einem gleichen Abstand von ihren Seiten beaufschlagt werden.

7

D158127

Im Anspruch 25 sind einfache Maßnahmen zur Ausbildung von Anschlägen enthalten, die die Bewegung der Spannbacken in Richtung auf ihre Gebrauchsstellung begrenzen.

Nachfolgend wird ein Ausführungsbeispiel der Erfindung anhand einer vereinfachten Zeichnung beschrieben.

Es zeigt

Fig. 1 eine erfindungsgemäß ausgestaltete Vorrichtung zum Greifen von elektronischen Bauelementen in einem Schnitt gemäß Linie I-I in Fig. 2;

Fig. 2 die Vorrichtung nach Fig. 1 im Schnitt nach der Linie II-II in Fig. 1;

Fig. 3 eine Unteransicht der Vorrichtung;

Fig. 4 zwei zueinandergehörige Spannbacken der Vorrichtung mit einem ergriffenen Bauelement.

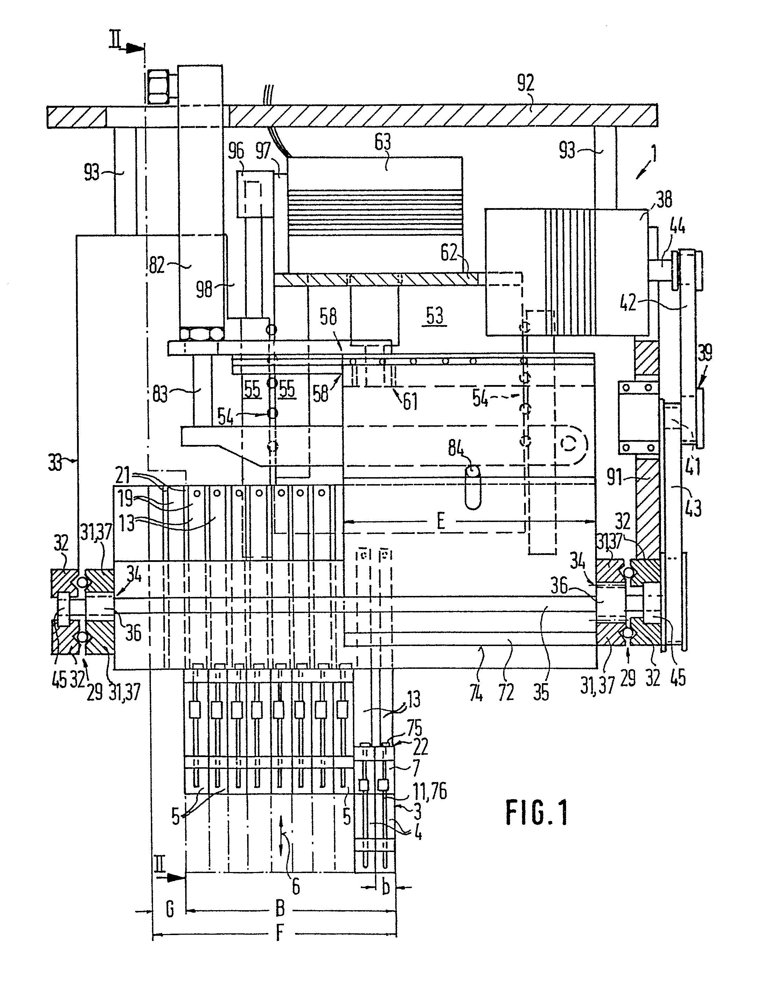

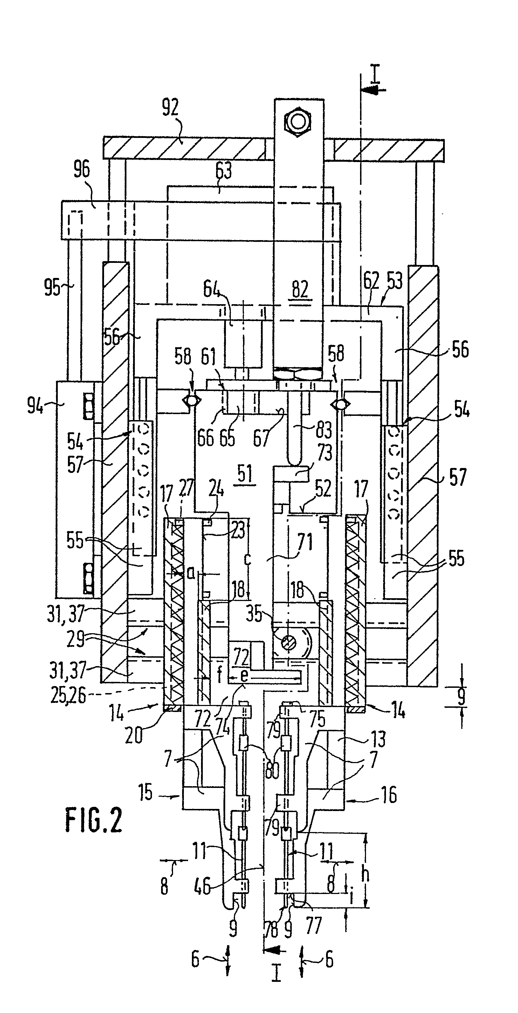

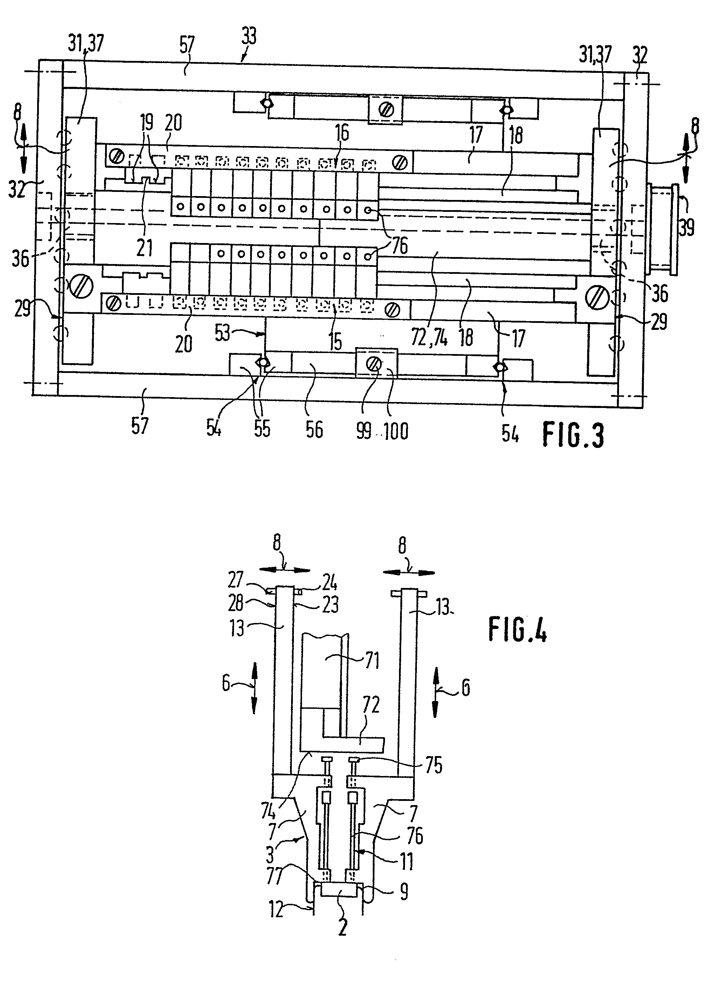

Die in Fig. 1 allgemein mit 1 bezeichnete Vorrichtung dient dazu, elektronische Bauelemente, insbesondere mit 2 bezeichnete IC's an einem nicht dargestellten Entnahmeort aufzunehmen, zu einem nicht dargestellten Einsatzort zu transportieren und am Einsatzort abzulegen oder in eine definierte Stellung, beispielsweise eine Montagestellung in einer ebenfalls nicht dargestellten Leiterplatte, einzustecken. Zum Greifen der IC's weist die Vorrichtung 1 eine allgemein mit 3 bezeichnete Greifzange auf, die aus mehreren in einer Reihe angeordneten Zangenabschnitten 4,5 besteht. Während die Zangenabschnitte 5 in noch zu erkärender Weise zwischen einer zurückgezogenen Bereitschaftsstellung (Fig. 1 mit durchgezogenen Linien gezeichnet) und einer vorgeschobenen Gebrauchsstellung (strich-punktiert gezeichnet) verschiebbar sind, sind die Zangenabschnitte 4 in dieser Bewegungsrichtung (Doppelpfeil 6) starr in der Vorrichtung 1 gehalten. Die Zangenabschnitte 5 sind jeweils einzeln in die Gebrauchsstellung schiebbar. Auf diese Weise ist die Breite B der Greifzange 3 variabel; sie kann an die Länge des in Fig. 1 nicht dargestellten IC's angepaßt werden, so daß das IC auf maximaler Länge übergriffen werden kann.

Jeder Zangenabschnitt 4,5 besteht aus zwei zueinandergehörigen Spannbacken 7, die translatorisch aufeinanderzu und voneinanderweg bewegbar sind (Doppelpfeil 8), wobei die Spannbacken 7 gleichzeitig und mit gleicher Geschwindigkeit aufeinanderzu bzw. voneinanderweg bewegt werden. Die nur in Fig. 4 dargestellten IC's können somit durch eine Spannbewegung der Spannbacken 7 ergriffen werden. Die Vorrichtung 1 insgesamt kann durch einen nicht dargestellten Arm gegebenenfalls in mehreren Bewegungsebenen und Bewegungsrichtungen zum Einsatzort transportiert werden, an dem nach dem Lösen der Spannbacken 7 das IC 2 (Fig. 4) abgesetzt werden kann. Ein zielsicheres Absetzen bzw. Einsetzen an einer vorbestimmten Stelle ist dadurch möglich, daß die Spannflächen 9 der Spannbacken 7 zueinander parallel sowie parallel zum Doppelpfeil 6 ausgerichtet sind und den Spannbacken 7 Ausstoßer 11 zugeordnet sind, die ebenfalls parallel zum Doppelpfeil 6 verschiebbar sind. Das betreffende IC 2 wird somit beim Ausstoßen geführt und kann mit seinen Anschlußfahnen 12 zielsicher auch in kleine Montageöffnungen, beispielsweise in einer nicht dargestellten Leiterplatte, eingesetzt werden .

Die Form der Spannbacken 7 und der Ausstoßer 11 sind am besten aus Fig. 2 ersichtlich. Die vorhandenen Spannbacken 7 sind einander gleich und weisen jeweils einen Schaft 13 auf, der gegenüber den Spannflächen 9 nach außen versetzt ist und längs des Doppelpfeils 6 in

einer ersten Führung 14 verschiebbar ist. Jeder Reihe 15,16 der Spannbacken 7 ist eine erste Führung 14 zugeordnet, die jeweils durch einen Abstabd a zwischen sich aufweisenden Führungsplatten 17,18 gebildet sind, von denen die jeweils innere Führungsplatte 18 um das Maß c niedriger bemessen ist als die jeweils äußere Führungsplatte 17. Zwischen den Führungsplatten 17,18 sind die Spannbacken 7 mit ihren Schäften 13 geführt. Die inneren Führungsplatten 18 weisen Führungsnuten 19 bzw. Führungsstege 21 zur Führung der Schäfte 13 auf, die bei 22 gegenüber der Breite b der Spannbacken 7 um das Maß der Führungsstege 21 verjüngt sind. Die Anordnung ist so getroffen, daß die Spannbackenabschnitte 4,5 mit ihren einander zugewandten Seiten unmittelbar aneinanderliegen. Dies ist jedoch keine Notwendigkeit, denn es könnte auch ein Abstand zwischen den einzelnen Spannbackenabschnitten 4,5 vorgesehen sein.

Von jeder Innenseite 23 der Schäfte 13, die -wie schon angeführt- gegenüber der Spannfläche 9 nach außen versetzt ist, springt am oberen Ende ein Ansatz 24 vor, der die Oberseite der jeweils inneren Führungsplatte 18 übergreift. Die Ansätze 24 stellen somit Anschläge dar, die die Gebrauchsstellung der beweglichen Zangenabschnitte 5 definieren. Der Hub h der Spannbacken 7 entspricht somit ungefähr dem Maß c.

Jede Spannbacke 7 ist durch eine Druckfeder 25 in Richtung auf ihre Bereitschaftsstellung vorgespannt. Die Druckfedern 25 sind in Nuten 26 angeordnet, die in die Innenseiten der äußeren Führungsplatten 17 eingearbeitet sind, und wirken jeweils gegen einen Ansatz 27, der von der Außenseite 28 jeden Schaftes 13 vorspringt. Die Nuten 26 sind an einem Ende durch an die Führungsplatten 27 angeschraubte Leisten 2o abgedeckt, an denen sich auch die Druckfedern 25 abstützen.

Die ersten Führungen 14 sind in zweiten Führungen 29 in Richtung des Doppelpfeiles 8 geführt. Die Spann-

bzw. Lösebewegung (Doppelpfeil 8) erfolgt für alle Spannbacken 7 der Reihen 15,16 gleichzeitig. Deshalb nehmen auch die sich in Bereitschaftsstellung befindlichen Zangenabschnitte 5 an den Spann- bzw. Lösebewegungen teil, obwohl sie nicht benutzt werden. Dies ist jedoch völlig unerheblich, denn eine Ausgestaltung, bei der nur die in der Gebrauchsstellung befindlichen Spannbacken 7 an der Spann- bzw. Lösebewegung (Doppelpfeil 8) teilnehmen würden, wäre außerordentlich kompliziert sowie vielgliedrig und würde eine erheblich größere Baugröße erfordern.

Die an beiden Enden der Führungsplatten 17,18 angeordneten zweiten Führungen 29 werden durch an sich bekannte Kugelführungen mit Führungsleisten 31,32 gebildet, von denen die mit 31 bezeichneten an den Führungsplatten 17,18 befestigt sind und diese gleichzeitig auf Distanz halten, und von denen die mit 32 bezeichneten an einem allgemein mit 33 bezeichneten Gehäuse befestigt sind, das noch zu beschreiben ist. Der Antrieb für die Spann- bzw. Lösebewegung (Doppelpfeil 8) der Spannbacken 7 wird durch einen allgemein mit 34 bezeichneten Zahnstangenantrieb verwirklicht, der eine sich zwischen den ersten Führungen 14 und zwischen den jeweils in doppelter Anzahl vorhandenen Führungsleisten 31,32 erstreckende Welle 35 umfaßt, auf der zwei Ritzel 36 befestigt sind, die mit den als Zahnstangen 37 ausgebildeten innenseitigen Führungsleisten 31 zusammenwirken. Die Führungsleisten 31 sind hierzu auf ihren einander zugewandten Seiten verzahnt. Die Welle 35 ist durch einen Schrittschaltmotor 38 antreibbar, wobei zwischen diesem und der Welle 35 ein zweistufiger Zahnriementrieb 39 mit einer frei drehenden Zwischenwelle 41 vorgesehen ist. Die Zahnriemen sind mit 42,43 bezeichnet. Der zweistufige Zahnriementrieb 39 ist im Sinne einer Untersetzung ausgebildet, d.h., die Welle 35 dreht erheblich langsamer als die Antriebswelle 44 des Schrittschaltmotors 38. Die Welle 35 ist durch Kugellager 45 gelagert,
die in Ausnehmungen der gehäuseseitigen Führungsleisten
32 aufgenommen sind. Von den Führungsleisten 31,32 ist
jeweils ein miteinander zusammenwirkendes Paar einer
ersten Führung 14 zugeordnet. D.h., die in der Zeichnung
unteren,inneren Führungsleisten 31 sind starr an dem
in Fig. 2 linken Führungsblock (Führungsplatten 17,18)
befestigt und die oberen,inneren Führungsleisten 31 sind
an dem in der Fig. 2 rechten Führungsblock befestigt.
Aufgrund der vorbeschriebenen Anordnung des Zahnstangenantriebs 34 werden die beiden Führungen 14 gleichzeitig
und mit gleichen Geschwindigkeiten jeweils in einander
entgegengesetzten Richtungen bewegt. Infolgedessen werden die ergriffenen IC's immer in der Mittelstellung
(Mittelachse 46) gespannt, egal wie breit das betreffende
IC 2 ist.

Zur Verschiebung der Zangenabschnitte 5 in die Gebrauchsstellung ist ein Stößel 51 vorgesehen, der längs den
ersten Führungen 14  verschiebbar ist und mit einer
Druckfläche 52 gleichzeitig beide Schäfte 13 zueinander
gehöriger Spannbacken 7 zu beaufschlagen vermag. Der Hub
des Stößels 51 ist so groß bemessen, das er durch Druck
auf die oberen Enden der Schäfte 13 die Spannbacken 7
in die Gebrauchsstellung zu schieben vermag. Im Betrieb
bleibt der Stößel 51 in dieser Position stehen, wodurch
die vorgeschobenen Spannbacken 7 in ihrer Gebrauchsstellung fixiert sind. Nach dem Zurückziehen des Stößels
51 werden die vorgeschobenen Spannbacken 7 bzw. Zangenabschnitte 5 durch die Druckfedern 25 automatisch wieder
in ihre Bereitschaftsstellung      zurückgeschoben.
In der Zeichnung ist der Stößel 51 in seiner zurückgezogenen Stellung dargestellt. Der Stößel 51 ist an
einem allgemein mit 53 bezeichneten Block gehalten, der
längs der ersten Führungen 14 im Gehäuse 33 mittels
einer dritten Führung 54 verschiebbar ist. Die dritte Führung 54 wird durch vier Kugelführungen mit Führungsleisten 55 gebildet, die zum einen an den Schenkelstücken 56 des U-förmigen Blocks 53 (Fig. 2) und zum anderen an Platten 57 des Gehäuses 33 befestigt sind. Die Schenkel- stücke 56 übergreifen die ersten Führungen 14 in einem solchen Abstand (Fig. 2), daß die Bewegung der ersten Führungen 14 in den zweiten Führungen 29 möglich ist.

Der Stößel 51 ist nicht nur längs den ersten Führungen 14, sondern auch längs den Reihen 15,16 der Zangenabschnitte 4,5 verschiebbar, und zwar in einer vierten Führung 58, die ebenfalls durch eine Kugelführung mit Führungsleisten gebildet ist. Die Verschiebung des Stößels 51 in dieser vierten Führung 58 erfolgt ebenfalls durch einen Zahnstangentrieb, der allgemein mit 61 bezeichnet ist. Für diese Verschiebung ist auf dem Stegstück 62 des Blocks 53 ein zweiter Schrittschaltmotor 63 angeordnet, auf dessen Antriebswelle 64 ein Ritzel 65 sitzt, das mit einer Verzahnung 66 am Stößel 51 in einer Nut 67 kämmt. Wenn der Schrittschaltmotor 63 dreht, wird der Stößel 51 bei Vergleich der Fig. 1 nach links oder rechts längs den Reihen 15,16 der Zangenabschnitte 4,5 verschoben. Er kann somit wahlweise über die Zangenabschnitte 5 verschoben werden, die in die Gebrauchsstellung vorgeschoben werden sollen, um eine bestimmte Breite B der Greifzange 3 zu bilden. Wenn der Stößel 51 in der in Fig. 1 dargestellten Position in Richtung auf die Spannbacken 7 vorgeschoben werden würde, würde er lediglich den ersten beweglichen Zangenabschnitt 5 in die Bereitschaftsstellung verschieben. Die Breite E des Stößels 51 entspricht einem Maß F, das sich aus der Breite B der Greifzange 3 und einem Abstand G zusammensetzt, in dem noch weitere Führungsnuten 19 bzw. Führungsstege 21 zwecks Aufnahme weiterer Spannbacken 7 angeordnet sind. Die Breite B der Greifzange 3 kann —wie Fig. 1 deutlich zeigt- noch um zwei weitere Zangenabschnitte 5 bei Bedarf vergrößert werden.

Von der Druckfläche 52 des Stößels 51 springt etwa mittig ein Steg 71 vor, in dem parallel zur dritten Führung 54 und somit auch parallel zur ersten Führung 14 ein Ausstoßschieber 72 geführt ist, der sich in der dargestellten Position in seiner zurückgezogenen Stellung befindet und durch Schwenken eines Hebels 73 in Richtung auf die Spannbacken 7 vorgeschoben werden kann. Die Breite e des Ausstoßschiebers 72 ist so groß bemessen, daß seine Stirnfläche 74 die in den Spannbacken 7 verschiebbar geführten Ausstoßer 11 sowohl in der voneinander entferntesten Stellung der Spannbacken 7 als auch in deren einander am nächsten Stellung zu beaufschlagen vermag. Die Abstände $F$ zwischen den inneren Führungsplatten 18 und dem Ausstoßschieber 72 ermöglichen es, die Spannbacken 7 um ein beträchtliches Maß aufeinanderzuzubewegen, um auch schmale IC's 2 ergreifen zu können. In der vollends zusammengeschobenen Stellung der Spannbacken 7 liegen diese mit ihren aufeinanderzu gerichteten Seiten aneinander.

In seiner vorgeschobenen Stellung steht der Ausstoßschieber 72 unmittelbar vor den Köpfen 75 der durch Schubstangen 76 gebildeten Ausstoßer 11. D.h., in seiner zurückgezogenen Stellung weist der Ausstoßschieber 72 einen Abstand $G$ von den Köpfen 75 auf, der größer ist als der Abstand i zwischen den Anschlagflächen 77 der Spannbacken 7 und den Stirnenden 78 der Schubstangen 76 in deren vorgeschobener Position. Die Schubstangen 76 sind in Führungsbohrungen der Spannbacken 7 frei beweglich, d.h., sie fallen durch Eigengewicht in die in Fig. 1 und 2 dargestellte Position. Wenn ein IC 2 ergriffen wird, werden die Schubstangen 76 automatisch in ihre zurückgezogene Position zurückgeschoben. Die Schubstangen 76 sind in Vorsprüngen 79 gelagert, die auf den einander zugewandten Seiten der Spannbacken 7 angeordnet sind. Durch entsprechend angeordnete Klemmstücke 80 auf den Schubstangen 76 ist gewährleistet, daß die Schubstangen 76 nicht so weit zurückgeschoben werden können, daß ihre Stirnenden 78 außer Führung geraten.

Der Ausstoßschieber 72 ist durch eine nicht dargestellte Feder in Richtung auf seine zurückgeschobene Position (dargestellt) beaufschlagt. Das Vorschieben des Ausstoßschiebers 72 erfolgt durch einen Pneumatik-Zylinder 82, dessen Kolben 83 den Hebel 73 in Richtung auf die Spannbacken 7 zu verschwenken vermag. Beim Verschwenken wirkt der Hebel 73 gegen einen am Ausstoßschieber 72 befestigten Anschlagbolzen 84, der die Mitnahme des Ausstoßschiebers 72 bewirkt.

Der Ausstoßschieber 72 ist genauso breit (E) bemessen wie der Stößel 51. Da der Ausstoßschiber 72 an dessen Bewegung teilnimmt, überdeckt der Ausstoßschieber 72 auch die gleichen Zangenabschnitte 5, die der Stößel 51 überdeckt, und vermag deren Schubstangen 76 zu beaufschlagen (siehe Fig. 1).

Das Gehäuse 33 der Vorrichtung 1 besteht aus einen Hohlraum zwischen sich einschließenden Platten, die auf vier Seiten des Gehäuses 33 angeordnet sind. Neben den schon angeführten, einander gegenüberliegenden Platten 57 ist noch eine mit diesen befestigte Platte 91 am zweistufigen Zahnriementrieb 39 und eine Deckplatte 92 vorhanden, die durch vier Distanzbolzen 93 mit den Platten 57 verbunden ist, um Montageöffnungen zwischen den Platten 57,91 und 92 zu schaffen.

Zur Verschiebung des Stößels 51 bzw. des ihn tragenden Blocks 53 ist ein zweiter Pneumatik-Zylinder 94 auf einer Außenseite des Gehäuses 33 vorgesehen, dessen Kolbenstange 95 mit einer Traverse 96 verbunden ist, die an einem aufwärts gerichteten Steg 97 des Blocks 53 befestigt ist. Damit der Block 53 den erforderlichen Hub ausführen kann, ist die betreffende Platte 57 unterhalb der Traverse 96 bei 98 ausgespart.

Die vorgeschobene Stellung des Stößels 51 ist durch verstellbare Anschläge in Form von nur in Fig. 3 dargestellten Stellschrauben 99 einstellbar, die in innenseitig am Gehäuse 33 befestigten Anschlagstücken 1oo eingeschraubt sind.

Die Vorrichtung 1 kann zu ihrer Handhabung z.B. mit ihrer Deckplatte 92 an einem nicht dargestellten Arm befestigt werden, der bevorzugt in mehreren Ebenen bzw. Richtungen verstellbar bzw. schwenkbar ist. Dabei können die Bewegung des Arms und auch die einzelnen Bewegungen der Vorrichtungsteile (Zangenabschnitte 4,5, Spannbacken 7, Stößel 51, Ausstoßschieber 72) durch ein Programm automatisch gesteuert werden.

ANSPRÜCHE

1. Vorrichtung zum Greifen von elektronischen Bauelementen, insbesondere IC's, mit einer Greifzange, deren Spannbacken aufeinanderzu und voneinanderweg beweglich sind, dadurch gekennzeichnet, daß die Greifzange (3) in mehrere in einer Reihe (15,16) angeordnete Zangenabschnitte (4,5) unterteilt ist, von denen wenigstens ein Zangenabschnitt (5) in einer ersten Führung (14) zwischen einer zurückgezogenen Bereitschaftsstellung (mit durchgezogenen Linien gezeichnet) und einer vorgeschobenen Gebrauchsstellung (strich-punktiert gezeichnet) verschiebbar ist.

2. Vorrichtung nach Anspruch 1, dadurch gekennzeichnet, daß die Zangenabschnitte (4,5) durch eine Federkraft (25) in Richtung auf ihre Bereitschaftsstellung vorgespannt und durch Stößel (51) in ihre Gebrauchsstellung verschiebbar sind.

3. Vorrichtung nach Anspruch 1 oder 2, dadurch gekennzeichnet, daß zueinandergehörige Spannbacken (7) zwischen der Be-

0158127

reitschaftsstellung und der Gebrauchsstellung getrennt verschiebbar und in einer zweiten Führung (29)
translatorisch aufeinanderzu und voneinanderweg beweglich sind.

4. Vorrichtung nach Anspruch 3,
dadurch gekennzeichnet,
daß die Spannbacken (7) gleichzeitig und mit gleicher
Geschwindigkeit aufeinanderzu und voneinanderweg beweglich sind.

5. Vorrichtung nach einem der Ansprüche 1 bis 4,
dadurch gekennzeichnet,
daß die erste Führung aus zwei voneinander unabhängigen Führungen (14) besteht, die in der zweiten
Führung (29) verschiebbar sind.

6. Vorrichtung nach Anspruch 5,
dadurch gekennzeichnet,
daß die ersten Führungen (14) durch Führungsblöcke
gebildet sind, die sich längs den Reihen (15,16) der
Spannbacken (7) erstrecken und jeweils alle Spannbacken (7) einer Reihe (15,16) aufnehmen.

7. Vorrichtung nach Anspruch 6,
dadurch gekennzeichnet,
daß die Führungsblöcke jeweils durch zwei voneinander
beabstandete Führungsplatten (17,18) gebildet sind,
von denen jeweils wenigstens eine Führungsnuten (19)
oder Führungsstege (21) aufweist, die mit Führungsflächen an den Spannbacken (7) bzw. an Führungsschäften (13) derselben zusammenwirken.

8. Vorrichtung nach Anspruch 7,
dadurch gekennzeichnet,
daß die Führungsplatte (18) Führungsstege (21) aufweist, die den Führungsschaft (13) seitlich übergreifen.

9. Vorrichtung nach Anspruch 7 oder 8,

   dadurch gekennzeichnet,

   daß wenigstens eine Führungsplatte (17,18) in der
   Anzahl der Zangenabschnitte (4,5) vorhandene Nuten
   (26) bevorzugt in der Führungsfläche aufweist, in
   denen Druckfedern (25) angeordnet sind, die an ihrem
   einen Ende von in die Nuten (26) eingreifenden Ansätzen (27) der Führungsschäfte (13) übergriffen
   sind und sich an ihren anderen Enden an der Führungsplatte (17,18) abstützen.

10. Vorrichtung nach einem der Ansprüche 3 bis 9,

    dadurch gekennzeichnet,

    daß jeder ersten Führung (14) wenigstens eine sich
    parallel zur zweiten Führung (29) erstreckende Zahnstange (37) zugeordnet ist, die einen Abstand voneinander aufweisen, und zwischen denen ein mit den Zahnstangen (37) kämmendes, antreibbares Ritzel (36) angeordnet ist.

11. Vorrichtung nach Anspruch 1o,

    dadurch gekennzeichnet,

    daß die zweiten Führungen (29) durch Führungsleisten
    (31,32) gebildet sind und die den ersten Führungen
    (14) zugeordneten Führungsleisten (31) auf ihren einander zugewandten Seiten verzahnt sind.

12. Vorrichtung nach Anspruch 1o oder 11,

    dadurch gekennzeichnet,

    daß an beiden Enden der ersten Führung (14) zwei Zahnstangen (37) und ein Ritzel (36) vorgesehen sind
    und daß die Ritzel (36) auf einer durchgehenden Welle
    (34) angeordnet sind, die durch einen Schrittschalt-
    motor (38) antreibbar ist.

0158127

13. Vorrichtung nach Anspruch 3 oder 4,
dadurch gekennzeichnet,
daß zueinandergehörige Spannbacken (7) durch einen
gemeinsamen Stößel (51) gleichzeitig verschiebbar
sind.

14. Vorrichtung nach einem der Ansprüche 2 bis 13,
dadurch gekennzeichnet,
daß der Stößel (51) breiter bemessen ist (E) als die
Breite (b) eines Zangenabschnitts (4,5), bevorzugt
wenigstens so breit bemessen ist, wie die Breite (B)
der Greifzange (3) und in einer vierten Führung (58)
parallel zur Reihe der Zangenabschnitte (4,5) verschiebbar ist.

15. Vorrichtung nach einem der Ansprüche 1 bis 14,
dadurch gekennzeichnet,
daß die Führungsschäfte (13) der Spannbacken (7) gegenüber den zugehörigen Spannflächen (9) nach außen versetzt sind.

16. Vorrichtung nach Anspruch 14 oder 15,
dadurch gekennzeichnet,
daß die wahlweise zu bildende Reihe (15,16) von Zangenabschnitten (4,5) etwa in der Mitte der Vorrichtung
(1) beginnt und vor dem ersten Zangenabschnitt (4)
ein Freiraum in der Breite (E) des Stößels (51) in
der Vorrichtung (1) vorgesehen ist.

17. Vorrichtung nach einem der Ansprüche 1 bis 16,
dadurch gekennzeichnet,
daß den Zangenabschnitten (4,5) verschiebbare Ausstoßer (11) für die Bauelemente (2) zugeordnet sind.

5

18. Vorrichtung nach Anspruch 17,
dadurch gekennzeichnet,
daß die Ausstoßer (11) durch Schubstangen (76) gebildet sind, die in der Nähe der Spannflächen (9)
in den Spannbacken (7) verschiebbar gelagert sind.

19. Vorrichtung nach Anspruch 18,
dadurch gekennzeichnet,
daß die Schubstangen (76) an ihren dem Bauelement abgewandten Enden Köpfe (75) aufweisen.

2o. Vorrichtung nach Anspruch 18 oder 19,
dadurch gekennzeichnet,
daß die Schubstangen (76) in voneinander beabstandeten
Vorsprüngen (79) auf den Innenseiten der Spannbacken
(7) gelagert sind, und zwischen den Vorsprüngen (79)
Schultern (81) auf den Schubstangen (76) sitzen, die
Anschläge für die Einschubbewegung der Schubstangen
(76) bilden.

21. Vorrichtung nach einem der Ansprüche 17 bis 2o,
dadurch gekennzeichnet,
daß die Ausstoßer (11) eines Zangenabschnitts (4,5)
durch einen parallel zu den Schubstangen (76) verschiebbaren Ausstoßschieber (72) verschiebbar sind.

22. Vorrichtung nach Anspruch 21,
dadurch gekennzeichnet,
daß die Ausstoßer (11) mehrerer hintereinander liegender Zangenabschnitte (4,5) bevorzugt aller Zangenabschnitte (4,5) durch einen entsprechend breit bemessenen Ausstoßschieber (72) beaufschlagbar sind,
der parallel zur Reihe der Zangenabschnitte (4,5)
verschiebbar ist.

0158127

23. Vorrichtung nach Anspruch 2o oder 21,

   dadurch gekennzeichnet,

   daß der Ausstoßschieber (72) vom Stößel (51) getragen
   und längs seiner Ausstoßbewegung im Stößel (51) verschiebbar geführt ist.

24. Vorrichtung nach Anspruch 23,

   dadurch gekennzeichnet,

   daß der Ausstoßschieber (72) durch einen Hebel (73)
   verschiebbar ist, der im Stößel (51) gelagert ist
   und durch einen besonderen Antrieb, bevorzugt in
   Form eines pneumatischen Zylinders (94) antreibbar
   ist.

25. Vorrichtung nach einem der Ansprüche 7 bis 24,

   dadurch gekennzeichnet,

   daß eine der zueinandergehörigen Führungsplatten (17,
   18) längs der ersten Führung (14) schmaler bemessen
   ist als die andere Führungsplatte (17,18) oder Einschnitte aufweist und mit ihren den freien Enden
   der Spannbackenschäfte (13) zugewandten Seiten oder
   Einschnitten Anschläge für die Ausschubbewegung der
   Spannbacken (7) bilden.

26. Vorrichtung nach einem der Ansprüche 1 bis 25,

   dadurch gekennzeichnet,

   daß die Spannbacken (7) ebene Spannflächen (9) aufweisen, die parallel zueinander und parallel zur
   Schubbewegung (Doppelpfeil 6) der Spannbacken (7)
   ausgerichtet sind.

FIG.1

FIG.2

FIG.3

FIG.4